# EUROPEAN PATENT APPLICATION

(11) **EP 4 726 960 A1**
(43) Date of publication of application: **15.04.2026**
(21) Application number: 25206328.4
(22) Date of filing: 02.10.2025
(51) Int. Cl.: H02J 7/40, H02J 7/47, H02J 7/60

(54) **BATTERY PROTECTION CIRCUIT MODULE TO WHICH AUTHENTICATION CIRCUIT UNIT IS APPLIED AND METHOD OF PROTECTING AUTHENTICATION CIRCUIT UNIT USING THE SAME**

(30) Priority: 08.10.2024 KR 20240137179
(71) Applicant: SAMSUNG SDI CO., LTD., Yongin-si, Gyeonggi-do 17084 (KR)
(72) Inventor: PARK, Seokryun, 17084 Yongin-si (KR)
(74) Representative: Marks & Clerk LLP

(57) **Abstract**

The present disclosure relates to a battery protection circuit module to which an authentication circuit unit (410; 420) is applied and a method of protecting an authentication circuit unit (410; 420) using the same, and more particularly, to a battery protection circuit module including a part arrangement design that is robust against external environment noise and a method of protecting an authentication circuit unit (410; 420) using the same. A battery protection circuit module to which an authentication circuit unit (410; 420) is applied may include an authentication circuit unit (410; 420) connected to an output stage of the battery protection circuit module and a protection device configured to protect the authentication circuit unit (410; 420) against external noise.

## Description

### BACKGROUND

### 1. Technical Field

The present disclosure relates to a battery protection circuit module to which an authentication circuit unit is applied and a method of protecting an authentication circuit unit using the same, and more particularly, to a battery protection circuit module including a part arrangement design that is robust against external environment noise and a method of protecting an authentication circuit unit using the same.

### 2. Related Art

According to the conventional technology, the arrangement and design of parts based on a plurality of protection circuit devices (e.g., an integrated circuit (IC) and a field effect transistor (FET)) are performed. In accordance with regulations that the EU's parliament recently approved legislation that requires a manufacturer to allow users to easily remove/replace batteries included in portable devices, it is necessary to self-replace a battery and essential to apply an IC for recognizing an authentic battery.

### SUMMARY

Embodiments of the present disclosure are directed to providing a battery protection circuit module capable of securing robust characteristics from external environment noise (e.g., surge, electrical overstress (EOS), or electrostatic discharge (ESD)) according to the required application of an authentication circuit unit through the design and arrangement of parts around an authentication IC, and a method of protecting an authentication circuit unit using the same.

A battery protection circuit module to which the authentication circuit unit is applied according to embodiments of the present disclosure includes, an authentication circuit unit connected to an output stage of the battery protection circuit module, and a protection device configured to protect the authentication circuit unit against external noise.

The protection device may be connected to a terminal of the authentication circuit unit and may be differently disposed depending on the specifications of a manufacturer.

According to the specifications of a first manufacturer, the protection device may include a first resistor disposed to have a resistance value within a predetermined range at a first preset node of the authentication circuit unit.

According to the specifications of a first manufacturer, the protection device may include a first capacitor disposed to have a capacitance value within a predetermined range at a second preset node of the authentication circuit unit.

According to the specifications of a second manufacturer, the protection device may include a second capacitor disposed to have a capacitance value within a predetermined range at a first preset node of the authentication circuit unit.

According to the specifications of a second manufacturer, the protection device may include a third capacitor disposed to have a capacitance value within a predetermined range at a second preset node of the authentication circuit unit.

A protection device including a bidirectional diode may be disposed in an output stage of the authentication circuit unit.

A battery protection circuit module to which the authentication circuit unit is applied according to embodiments of the present disclosure may include an authentication circuit unit that is connected to an output stage of the battery protection circuit module and into which authentication circuit product characteristics of a plurality of manufacturers have been incorporated and a protection device configured to protect the authentication circuit unit against external noise.

The protection device may be disposed through pin-to-pin arrangement and may protect the authentication circuit unit.

The authentication circuit unit may include an authentication circuit of a first manufacturer and an authentication circuit of a third manufacturer. The authentication circuit unit may be driven and executed by recognizing a set resistance value.

The protection device may include a resistor disposed in each output unit for each of the first manufacturer and the third manufacturer.

In the case of the third manufacturer, a resistor connected to the authentication circuit of the first manufacturer may not be mounted, a resistor connected to the authentication circuit of the third manufacturer may be mounted, and the authentication circuit unit may be driven by recognizing a resistance value of the resistor connected to the output stage and may recognize the pull-up of the resistor through an output terminal of the third manufacturer.

The authentication circuit unit may be driven by recognizing a resistance value of the resistor connected to the output stage and recognizes the pull-down of the resistor through an output terminal of the first manufacturer.

A method of protecting an authentication circuit unit according to embodiments of the present disclosure includes steps of (a) designing a protection device for an authentication circuit unit included in the battery protection circuit module, (b) disposing the protection device, and (c) performing the application of external noise and protection-related verification for the authentication circuit unit.

The step (a) may include designing the specifications of the protection device that protect the authentication circuit unit connected to an output stage of the battery protection circuit module against external noise.

The step (a) may include designing a first resistor that is connected to a first preset node of the authentication circuit unit and that has a resistance value within a preset range and a first capacitor that is disposed at a second preset node of the authentication circuit unit and that has a capacitance value within a preset range, according to the specifications of a first manufacturer.

The step (a) may include designing a second capacitor that is connected to a first preset node of the authentication circuit unit and that has a capacitance value within a preset range and a third capacitor that is connected to a second preset node of the authentication circuit unit and that has a capacitance value within a preset range, according to the specifications of a second manufacturer.

The step (b) may include disposing the protection device by determining whether a resistor disposed in an output unit of an authentication circuit for each manufacturer has been mounted or has not been mounted.

The step (b) may include recognizing the pull-up or pull-down of the resistor depending on whether the resistor disposed in the output unit for each manufacturer has been mounted or has not been mounted.

The step (c) may include performing verification on at least one of ESD, an overvoltage, an inverse voltage, a surge voltage, and confirmation of ROM information of the authentication circuit unit after a radiation of X-ray.

According to the embodiments of the present disclosure, a new device verification issue can be solved in preparation for an external environment according to the application of a new memory IC and the occurrence of electrical noise within a process. The authentication circuit unit can be protected when a facility is exposed to an inverse voltage and a surge voltage during function tests and hardware tests. Accordingly, it is possible to secure reliability when a pack model to which a new authentication circuit unit has been applied is exposed to an electrical environment. The application of the same platform and horizontal deployment related to a surrounding device of the pack model are possible.
At least some of the above and other features of the invention are set out in the claims.

### BRIEF DESCRIPTION OF THE DRAWINGS

The following drawings attached to this specification illustrate preferred embodiments of the present disclosure, and help to further understand the technical disclosure along with the aforementioned contents of the disclosure. Accordingly, the present disclosure should not be construed as being limited to only contents described in such drawings:
IG. 1 schematically illustrates an electrode assembly of a secondary battery;
FIG. 2 schematically illustrates a configuration of a pouch-type secondary battery;
FIG. 3 illustrates a schematic external appearance configuration of a prismatic secondary battery;
FIG. 4 is a cross-sectional view of a cylindrical secondary battery;
FIG. 5 illustrates a battery protection circuit module to which an authentication circuit unit has been applied according to embodiments of the present disclosure.
FIG. 6 illustrates a construction of the authentication circuit unit and surrounding parts according to embodiments of the present disclosure.
FIG. 7 illustrates a battery protection circuit module to which a surrounding device has been applied by a plurality of authentication circuit unit products according to another embodiment of the present disclosure.
FIG. 8 illustrates the recognition and driving of an authentication circuit unit of a third manufacturer unit according to another embodiment of the present disclosure.
FIGS. 9 and 10 illustrate ESD verification according to embodiments of the present disclosure.
FIG. 11 illustrates a method of protecting an authentication circuit unit according to embodiments of the present disclosure.
FIG. 12 is a block diagram illustrating a computer system for implementing the method according to another embodiment of the present disclosure.
FIG. 13 is an example view of a secondary battery module in which secondary batteries manufactured according to examples of the present disclosure are arranged;
FIG. 14 is an example view of a secondary battery pack including the secondary battery module illustrated in FIG. 13; and
FIG. 15 is a conceptual view of a vehicle including the secondary battery pack illustrated in FIG. 14.
Fig. 16 illustrate 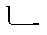 a method of charging a secondary battery.

### Detailed description

Hereinafter, example embodiments of the present disclosure will be described, in detail, with reference to the accompanying drawings. The terms or words used in the present specification and claims are not to be limitedly interpreted based on their general or ordinary meaning, and should be interpreted as meanings and concepts that are consistent with the technical idea of the present disclosure on the basis of the principle that an inventor can be their own lexicographer to appropriately define concepts of terms to describe their invention in the best way.

The example embodiments described in this specification and the configurations shown in the drawings are only some example embodiments of the present disclosure and do not represent all of the aspects of the present disclosure. Accordingly, it should be understood that there may be various equivalents and modifications that can replace or modify one or more example embodiments described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges is within the scope of this invention.

References to two compared elements, features, etc. As being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

When the terms "about" or "substantially" are used in this specification in connection with a numerical value, it is intended that the associated numerical value include a tolerance of ±10% around the stated numerical value. When ranges are specified, the range includes all values therebetween such as increments of 0.1%.

The terminology used herein is for the purpose of describing example embodiments of the present disclosure and is not intended to limit the present disclosure.

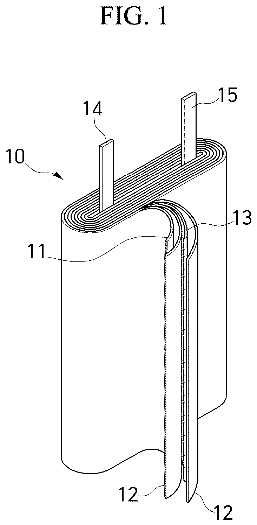

FIG. 1 schematically illustrates an electrode assembly built in a case of a secondary battery.

An electrode assembly 10 may be formed by winding or stacking a stack of a first electrode plate 11, a separator 12, and a second electrode plate 13, which are formed as thin plates or films. When the electrode assembly 10 is a wound stack, a winding axis may be parallel to the longitudinal direction (e.g., the y direction) of the case 59. In other example embodiments, the electrode assembly 10 may be a stack type rather than a winding type, and the shape of the electrode assembly 10 is not limited in the examples of the present disclosure. In addition, the electrode assembly 10 may be or include a Z-stack electrode assembly in which a positive electrode plate and a negative electrode plate are inserted into both sides of a separator, which is then bent into a Z-stack. In addition, one or more electrode assemblies may be stacked such that long sides of the electrode assemblies are adjacent to each other and accommodated in the case, and the number of electrode assemblies in the case is not limited in the examples of the present disclosure. The first electrode plate 11 of the electrode assembly may act as a negative electrode, and the second electrode plate 13 may act as a positive electrode. In examples, the reverse is also possible.

The first electrode plate 11 may be formed by applying a first electrode active material, such as graphite or carbon, to a first electrode current collector formed of a metal foil, such as copper, a copper alloy, nickel, or a nickel alloy. The first electrode tab 14 may be connected to an external first terminal (not shown). In some example embodiments, when the first electrode plate 11 is manufactured, the first electrode tab 14 may be formed by being cut in advance to protrude to one side of the electrode assembly 10, or the first electrode tab 14 may protrude to one side of the electrode assembly 10 more than, e.g., farther than or beyond, the separator 12 without being separately cut.

The second electrode plate 13 may be formed by applying a second electrode active material, such as a transition metal oxide, on a second electrode current collector formed of or including a metal foil, such as aluminum or an aluminum alloy. The second electrode plate 13 may include a second electrode tab 15 (e.g., a second uncoated portion) that is or includes a region to which the second electrode active material is not applied. The second electrode tab 15 may be connected to an external second terminal (not shown). In some example embodiments, the second electrode tab 15 may be formed by being cut in advance to protrude to the other side (e.g., the opposite side) of the electrode assembly 10 when the second electrode plate 13 is manufactured, or the second electrode plate 13 may protrude to the other side of the electrode assembly more than, e.g., farther than or beyond, the separator 12 without being separately cut.

In some example embodiments, the first electrode tab 14 may be located on the left side of the electrode assembly 10, and the second electrode tab 15 may be located on the right side of the electrode assembly 10. In other example embodiments, the first electrode tab 14 and the second electrode tab 15 may be located on one side of the electrode assembly 10 in the same direction.

Here, for convenience of description, the left and right sides are defined according to the electrode assembly 10 as oriented in FIG. 1, and the positions thereof may change when the secondary battery is rotated left and right or up and down.

The separator 12 hinders or substantially prevents a short-circuit between the first electrode 11 and the second electrode 13 while allowing movement of lithium ions therebetween. The separator 12 may be made of or include, for example, a polyethylene film, a polypropylene film, a polyethylene-polypropylene film, etc.

In some example embodiments, the electrode assembly 10 may be accommodated in the case (not shown) along with an electrolyte. In the case of a pouch-type secondary battery, an electrode assembly 10 may be accommodated in a pouch made of or including flexible material in the form illustrated in FIG. 1. In the case of a prismatic secondary battery, an electrode assembly 10 may be accommodated in a prismatic metal casing in the form illustrated in FIG. 1.

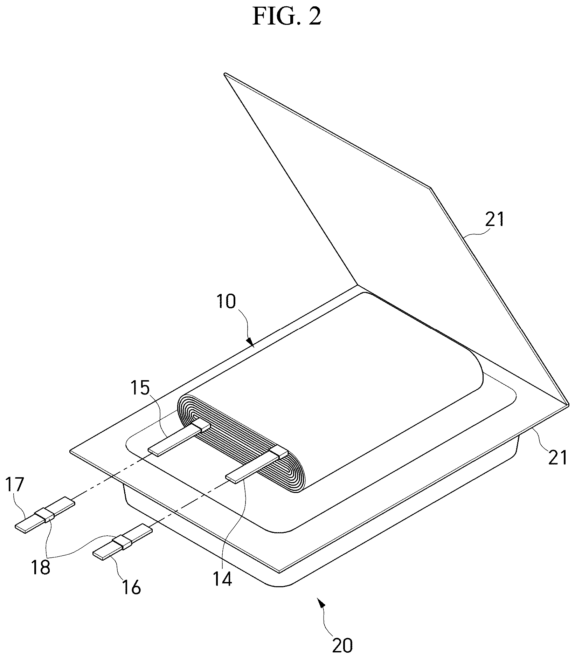

FIG. 2 schematically illustrates the pouch-type secondary battery.

The pouch-type secondary battery includes an electrode assembly 10 and a pouch 20 that accommodates or contains the electrode assembly 10 therein.

The electrode assembly 10 may be the same as the electrode assembly 10 illustrated in FIG. 1. The first electrode tab 14 and the second electrode tab 15 of the electrode assembly 10 may be electrically connected to respective external first and second terminal leads 16 and 17 by ,e.g., welding or other attaching method that preserves conductivity therebetween. At least a portion of each of the first terminal lead 16 and the second terminal lead 17 may be attached or covered with a tab film 18 for insulation from the pouch 20.

The pouch 20 may be sealed by having sealing parts 21 at the edges thereof come into contact with each other while accommodating or containing the electrode assembly 10 therein, in which case the sealing may be achieved with the tab film 18 interposed between the sealing parts 21. The sealing parts 21 of the pouch 20 may be made of or include a thermal fusion material that generally has weak adhesion to metal. Thus, it may be fused to the pouch 20 by interposing the thin tab film 18 between the sealing parts 21.

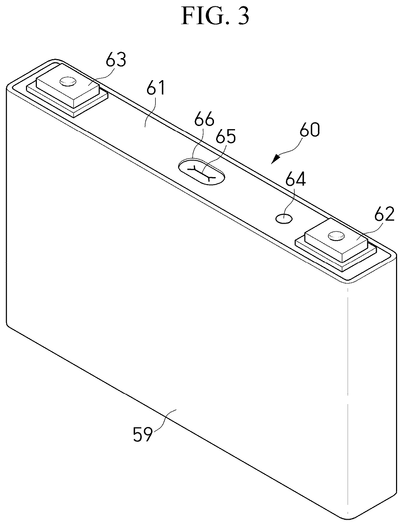

FIG. 3 illustrates a schematic external appearance configuration of a prismatic secondary battery.

A prismatic case 59 defines an overall appearance of the prismatic secondary battery, and may be made of or include a conductive metal, such as aluminum, aluminum alloy, or nickel-plated steel. In addition, the case 59 may provide a space for accommodating or containing the electrode assembly 10 therein.

A cap assembly 60 may include a cap plate 61 that covers an opening of the case 59, and the case 59 and the cap plate 61 may be made of or include a conductive material. A first terminal 63 and a second terminal 62 may be electrically connected to the first electrode tab 14 and the second electrode tab 15 of the electrode assembly 10 illustrated in FIGS. 1 and 2 inside the case 59, and may be installed to protrude outward through the cap plate 61.

The cap plate 61 may be equipped with or include an electrolyte injection port 64 configured to install a sealing plug therein, and a vent 66 formed that includes a notch 65 may be installed. The vent 66 is configured to discharge any gas generated inside the secondary battery.

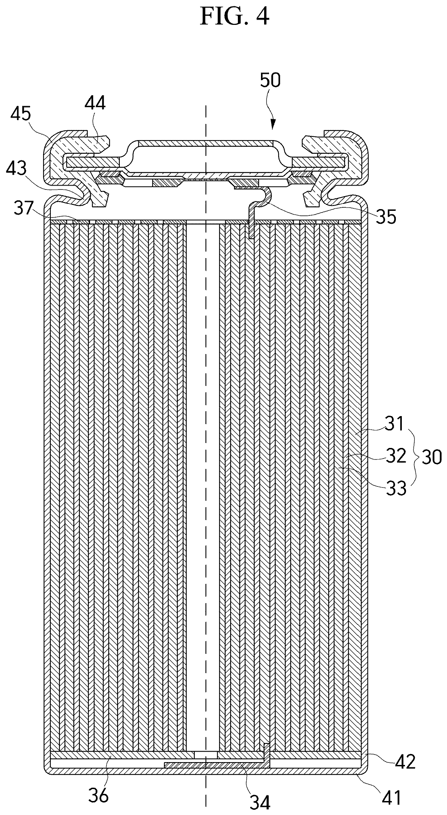

FIG. 4 is a cross-sectional view of a cylindrical secondary battery.

The cylindrical secondary battery includes an electrode assembly 30, a case accommodating the electrode assembly 30 and an electrolyte therein, a cap assembly 50 coupled to an opening of the case to seal the case, and an insulating plate 37 located between the electrode assembly 30 and the cap assembly 50 inside the case.

The electrode assembly 30 may include a separator 32 between a first electrode 33 and a second electrode 31, and the electrode assembly 30 may be wound in a jelly-roll form.

The first electrode 33 may include a first substrate and a first active material layer located on the first substrate. A first lead tab 35 may extend outward from a first uncoated portion of the first substrate where the first active material layer is not located, and may be electrically connected to the cap assembly 50.

The second electrode 31 may include a second substrate and a second active material layer located on the second substrate. A second lead tab 34 may extend outward from a second uncoated portion of the second substrate where the second active material layer is not located, and may be electrically connected to the case. The first lead tab 35 and the second lead tab 34 may extend in opposite directions with respect to each other.

The first electrode 33 may constitute a positive electrode. In this case, the first substrate may be composed of or include, for example, aluminum foil, and the first active material layer may include, for example, a transition metal oxide. The second electrode 31 may constitute a negative electrode. In this case, the second substrate may be composed of or include, for example, copper foil or nickel foil, and the second active material layer may include, for example, graphite.

The separator 32 may reduce or prevent a short-circuit between the first electrode 33 and the second electrode 31 while allowing movement of lithium ions therebetween. The separator 32 may be made of or include, for example, at least one of a polyethylene film, a polypropylene film, a polyethylene-polypropylene film, etc.

The case accommodates or contains the electrode assembly 30 and the electrolyte, and substantially forms the external appearance of the secondary battery together with the cap assembly 50. The case may have a substantially cylindrical body portion 42, and a bottom portion 41 connected to one side of the body portion 42. A beading part 43 deformed inwardly may be formed in the body portion 42, and a crimping part 45 bent inwardly may be formed at an open end of the body portion 42.

The beading part 43 may reduce or prevent movement of the electrode assembly 30 inside the case, and may facilitate seating of a gasket 44 and the cap assembly 50. A crimping part 45 may firmly fix the cap assembly 50 by pressing the edge of the cap assembly 50 against the gasket 44. The case may be formed of or include iron plated with nickel, for example.

The cap assembly 50 may be fixed to the inside of the crimping part 45 through the gasket 44 to seal the case. The cap assembly 50 may include a cap up, a safety vent, a cap down, an insulating member, and a subplate, but is not limited to this example and may be variously modified.

The cap up may be located at the very top of the cap assembly 50. The cap up may include a terminal portion that protrudes convexly upward and is connected to an external circuit, and an outlet for discharging gas may be located around the terminal portion.

The safety vent may be located below the cap up. The safety vent may include a protrusion that protrudes convexly downward and is connected to the subplate, and at least one notch located around the protrusion.

When gas is generated due to overcharging or abnormal operation of the secondary battery, the protrusion may be deformed upward by pressure and may separate from the subplate, while the safety vent may be cut along the notch. The cut safety vent may hinder or prevent the secondary battery from exploding by discharging gas to the outside.

The cap down may be located below the safety vent. The cap down may be formed with a first opening for exposing the protrusion of the safety vent and a second opening for discharging gas. The insulating member may be located between the safety vent and the cap down to insulate the safety vent and the cap down.

The subplate may be located below the cap down. The subplate may be fixed to a lower surface of the cap down to block the first opening of the cap down, and the protrusion of the safety vent may be fixed to the subplate. The first lead tab 35 pulled out from the electrode assembly 30 may be fixed to the subplate. Accordingly, the cap up, the safety vent, the cap down, and the subplate may be electrically connected to the first electrode 33 of the electrode assembly 30.

The insulating plate 37 may be located below the beading portion 43 to be in contact with the electrode assembly 30, and may be provided with a tab opening for pulling out the first lead tab 35. The cap assembly 50, which is electrically connected to the first electrode 33 by the first lead tab 35, may face the electrode assembly 30 with the insulating plate 37 interposed therebetween, and may maintain an insulated state from the electrode assembly 30 by the insulating plate 37. On the other hand, another insulating plate 36 may be included for insulation between the electrode assembly 30 and the bottom portion 41 of the case.

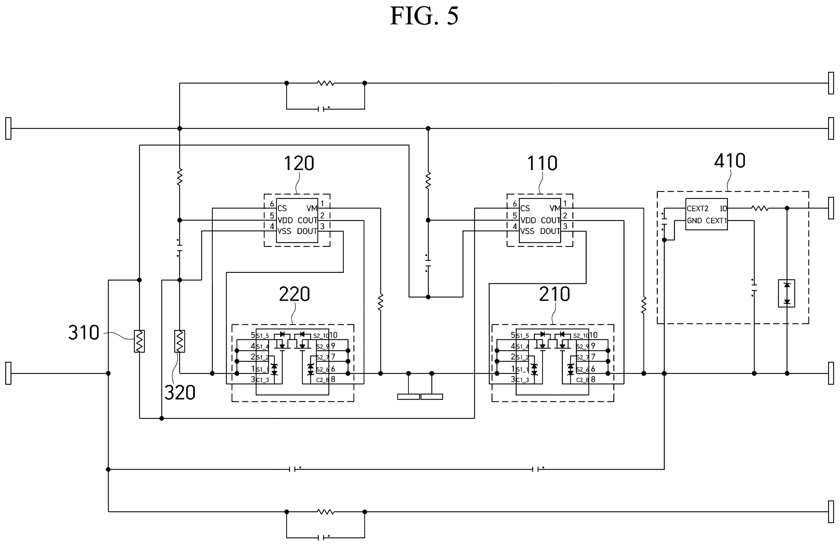

Hereinafter, prior to a description of embodiments of the present disclosure, problems of a model according to a conventional technology are described, and a battery protection circuit module to which an authentication circuit unit is applied and a method of protecting a battery according to embodiments of the present disclosure are described with reference to FIGS. 5 to 12.

Although it may be required to allow self-replacement of a battery, and to apply an IC for recognizing an authentic battery, according to the EU's regulations, there is a concern that an ROM ID of an authentication circuit unit may be lost and a failure mode will occur when ESD or EOS is exposed to an external environment whilst the authentication circuit unit is being applied. Furthermore, there is a danger that a function failure may occur in the authentication circuit unit due to an external peak surge voltage during function tests in a manufacturing process and other hardware test processes.

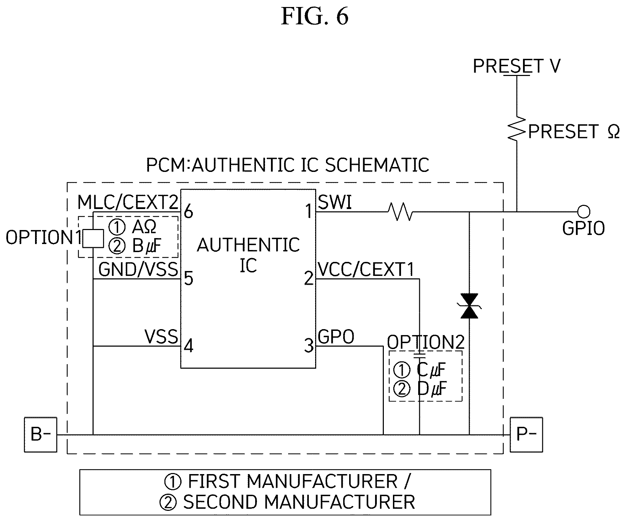

FIG. 5 illustrates a battery protection circuit module to which an authentication circuit unit has been applied according to embodiments of the present disclosure. FIG. 6 illustrates a construction of the authentication circuit unit and surrounding parts according to embodiments of the present disclosure.

The battery protection circuit module to which the authentication circuit unit has been applied according to embodiments of the present disclosure may include a first IC 110 disposed relatively closely to an output stage, a first FET 210 connected to the first IC 110, a second IC 120 disposed relatively closely to an input stage, and a second FET 220 connected to the second IC 120, and include an authentication circuit unit 410 connected to the output stage of the battery protection circuit module and a protection device that protects the authentication circuit unit 410 against external noise.

A different protection device may be connected to the terminal of the authentication circuit unit 410 depending on the specifications of a manufacturer.

According to the specifications of a first manufacturer, the protection device may include a first resistor disposed to have a resistance value within a predetermined range at a first preset node of the authentication circuit unit 410 (Option 1). The first resistor may be disposed to have resistance in a range of 0 to 10 ohm (A ohm).

According to the specifications of the first manufacturer, the protection device may include a first capacitor disposed to have a capacitance value within a predetermined range at a second preset node of the authentication circuit unit 410 (Option 2). The first capacitor may be disposed to have capacitance in a range of 0 to 1 microfarad (C microfarad).

According to the specifications of a second manufacturer, the protection device may include a second capacitor disposed to have a capacitance value within a predetermined range at the first preset node of the authentication circuit unit 410 (Option 1). The second capacitor may be disposed to have capacitance in a range of 1 to 3 microfarad (B microfarad).

According to the specifications of the second manufacturer, the protection device may include a third capacitor disposed to have a capacitance value within a predetermined range at the second preset node of the authentication circuit unit 410 (Option 2). The third capacitor may be disposed to have capacitance in a range of 0.1 to 1 microfarad (D microfarad).

The protection device including a bidirectional diode may be disposed in the output stage of the authentication circuit unit 410.

According to embodiments of the present disclosure, verification may be performed on the battery protection circuit module and a pack level by evaluating an external environment (e.g., ESD or an inverse voltage) depending on the type and setting value of the protection device that is disposed around the authentication circuit unit 410.

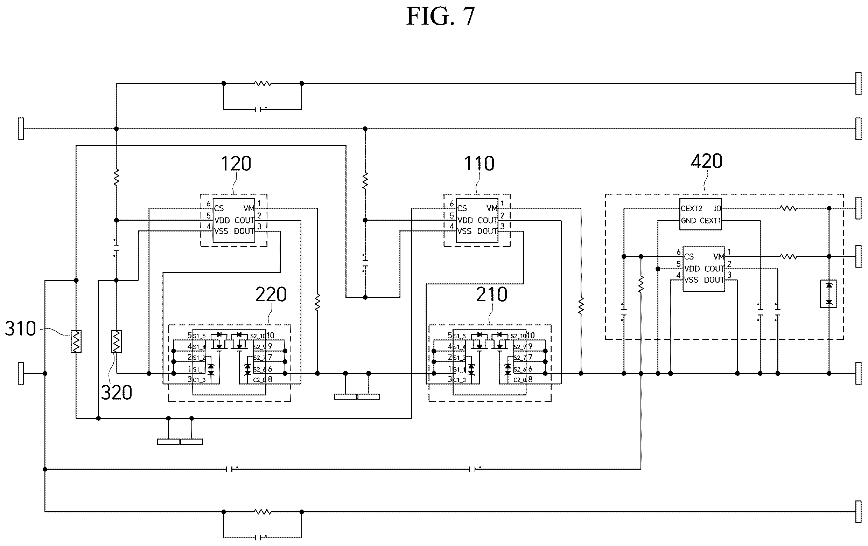

FIG. 7 illustrates a battery protection circuit module to which a surrounding device has been applied by a plurality of authentication circuit unit products according to another embodiment of the present disclosure.

The battery protection circuit module to which the authentication circuit unit has been applied according to another embodiment of the present disclosure may include a first IC 110 disposed relatively closely to an output stage, a first FET 210 connected to the first IC 110, a second IC 120 disposed relatively closely to an input stage, and a second FET 220 connected to the second IC 120, and may include an authentication circuit unit 420 that is connected to the output stage of the battery protection circuit module and into which authentication circuit product characteristics of a plurality of manufacturers have been incorporated and a protection device that protects the authentication circuit unit 420 against external noise.

According to another embodiment of the present disclosure, pin-to-pin arrangement is possible because the protection device has a different setting value in relation to authentication circuit product characteristics of a plurality of manufacturers, but an authentication circuit and a part have the same land size.

FIG. 7 illustrates that a lower authentication circuit of the authentication circuit unit 420 is an authentication circuit of a first manufacturer and an upper authentication circuit thereof is an authentication circuit of a third manufacturer.

A resistor may be disposed in each output unit for each of the first manufacturer and the third manufacturer. The authentication circuit unit 420 may drive and recognize the authentication circuit for each manufacturer.

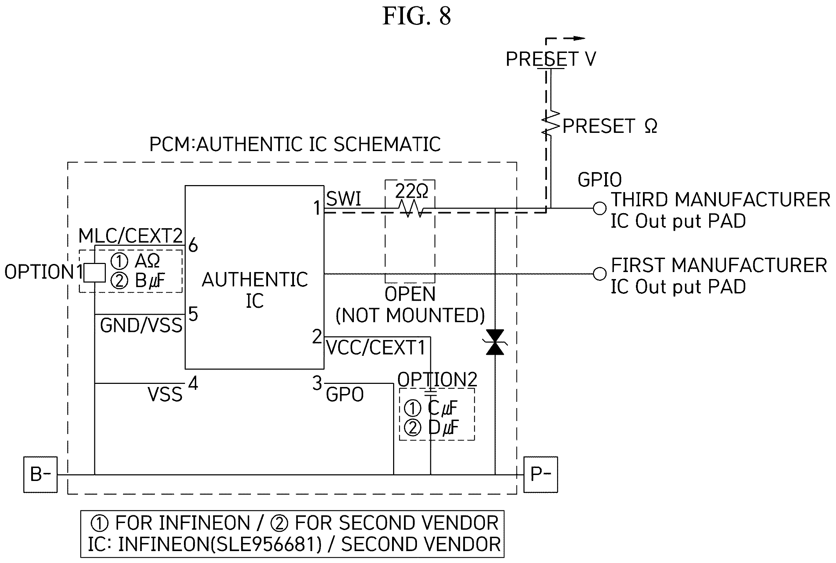

FIG. 8 illustrates the recognition and driving of the authentication circuit of the third manufacturer unit according to another embodiment of the present disclosure.

For example, in the case of the third manufacturer, a resistor connected to the authentication circuit of the first manufacturer may not be mounted (i.e., open), and a resistor connected to the authentication circuit of the third manufacturer may be mounted. The authentication circuit unit 420 may execute the driving of the authentication circuit by recognizing a resistance value of the resistor connected to the output stage.

Referring to FIG. 8, the authentication circuit unit 420 may recognize the pull-up of the resistor through the output terminal of the third manufacturer.

Referring to FIG. 8, the authentication circuit unit 420 may recognize the pull-down of the resistor through the output terminal of the third manufacturer.

According to another embodiment of the present disclosure, verification may be performed on the battery protection circuit module and a pack level by evaluating an external environment (e.g., ESD or an inverse voltage) depending on the type and setting value of a protection device that is disposed around the authentication circuit unit 420.

As described above, a different protection device may be connected to the terminal of the authentication circuit unit 420 depending on the specifications of a manufacturer. In Option 1, according to the specifications of the first manufacturer, the protection device may include a first resistor disposed to have a resistance value within a predetermined range at the first preset node of the authentication circuit unit 420. The first resistor may be disposed to have resistance in a range of 0 to 10 ohm (A ohm).

In Option 2, according to the specifications of the first manufacturer, the protection device may include a first capacitor disposed to have a capacitance value within a predetermined range at the second preset node of the authentication circuit unit 420. The first capacitor may be disposed to have capacitance in a range of 0 to 1 microfarad (C microfarad).

According to the specifications of a second manufacturer, the protection device may include a second capacitor disposed to have a capacitance value within a predetermined range at the first preset node of the authentication circuit unit 420 (Option 1). The second capacitor may be disposed to have capacitance in a range of 1 to 3 microfarad (B microfarad). The protection device may include a third capacitor disposed to have a capacitance value within a predetermined range at the second preset node of the authentication circuit unit 420 (Option 2). The third capacitor may be disposed to have capacitance in a range of 0.1 to 1 microfarad (D microfarad).

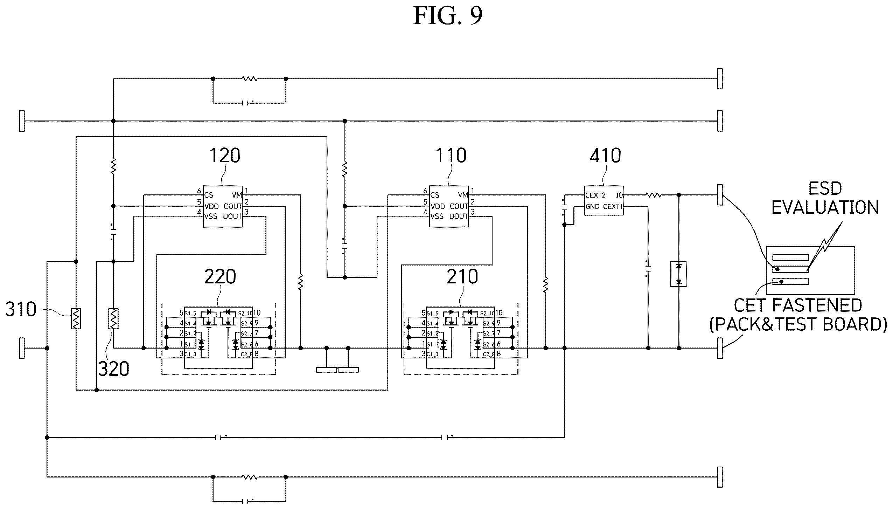

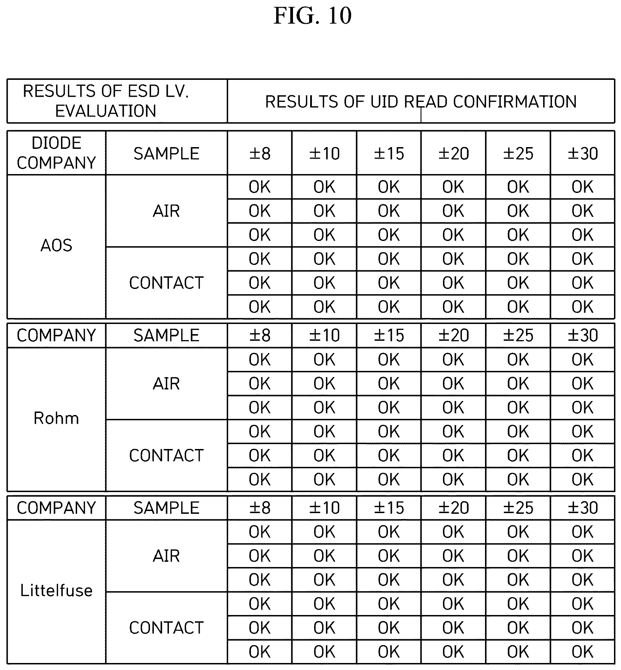

FIGS. 9 and 10 illustrate ESD verification according to embodiments of the present disclosure.

The output stage of the authentication circuit unit 410 and a CNT (contact) are fastened (pack and test board) according to embodiments of the present disclosure (for example by contactless electroplating technology (CET)). ESD evaluation may be performed. As a result of UID READ check related to a sample for each individual company (AIR, CONTACT), it can be seen that a reference value is satisfied by checking whether ESD is vulnerable for each diode manufacturer.

According to embodiments of the present disclosure, in addition to the ESD verification, a cell and the battery protection circuit module may be connected. The battery protection circuit module and a power supply may be connected. An initial voltage or current value (i.e., an initial value is set as an internal voltage of the FET) of the power supply may be set. Overvoltage and inverse voltage tests may be performed on the battery protection circuit module. As the results of the overvoltage and inverse voltage tests, the reference value was satisfied when the overvoltage and inverse voltage of 24 V or more were verified.

According to embodiments of the present disclosure, as the results of the evaluation of a surge voltage up to a maximum of 200 V and the check of ROM information of the authentication circuit unit after the radiation of X-ray, it was checked that the battery protection circuit module was reinforced against external noise.

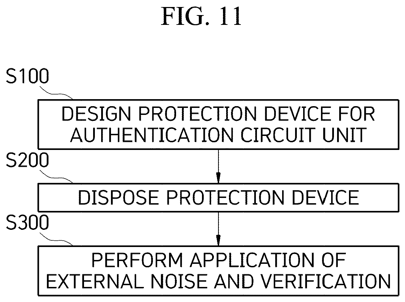

FIG. 11 illustrates a method of protecting an authentication circuit unit according to embodiments of the present disclosure.

The method of protecting an authentication circuit unit according to embodiments of the present disclosure includes step S100 of designing a protection device for the authentication circuit unit, step S200 of disposing the protection device, and step S300 of performing the application of external noise and verification.

In step S100, the protection device that protects the authentication circuit unit connected to the output stage of the battery protection circuit module against external noise may be determined.

In step S100, the protection device may include the first resistor that is connected to the first preset node of the authentication circuit unit and that has a resistance value within a preset range according to the specifications of the first manufacturer.

In step S100, the protection device may include the first capacitor that is disposed at the second preset node of the authentication circuit unit and that has a capacitance value within a preset range according to the specifications of the first manufacturer.

In step S100, the protection device may include the second capacitor that is connected to the first preset node of the authentication circuit unit and that has a capacitance value within a preset range according to the specifications of the second manufacturer.

In step S100, the protection device may include the third capacitor that is connected to the second preset node of the authentication circuit unit and that has a capacitance value within a preset range according to the specifications of the second manufacturer.

In step S100, the protection device may include a bidirectional diode connected to the output stage of the authentication circuit unit.

In step S200, pin-to-pin arrangement may be performed by considering authentication circuit product characteristics of a plurality of manufacturers.

In step S200, the protection device may be disposed in the authentication circuit unit based on a determination of whether a resistor disposed in the output unit has been mounted or has not been mounted for each manufacturer.

In step S200, in the case of the authentication circuit product of the third manufacturer, the resistor connected to the authentication circuit of the first manufacturer need not be mounted. The resistor connected to the authentication circuit of the third manufacturer may be mounted. The authentication circuit unit is driven by recognizing a resistance value of the resistor connected to the output stage, and may recognize the pull-up of the resistor through the output terminal of the third manufacturer.

In step S200, in the case of the authentication circuit of the first manufacturer product, the resistor connected to the authentication circuit of the third manufacturer need not be mounted. The resistor connected to the authentication circuit of the first manufacturer may be mounted. The authentication circuit unit may be driven by recognizing a resistance value of the resistor connected to the output stage, and may recognize the pull-down of the resistor through the output terminal of the first manufacturer.

In step S300, the output stage of the authentication circuit unit and the CNT may be fastened, and ESD evaluation may be performed.

In step S300, the battery protection circuit module and a cell may be connected, the battery protection circuit module and the power supply may be connected, and tests on at least any one of an overvoltage and an inverse voltage may be performed.

In step S300, a surge voltage may be evaluated.

In step S300, ROM information of the authentication circuit unit may be performed after the radiation of X-ray.

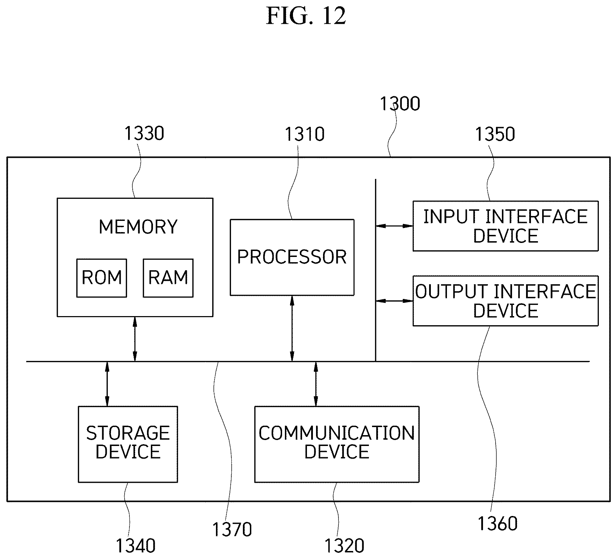

FIG. 12 is a block diagram illustrating a computer system for implementing the method according to another embodiment of the present disclosure.

Referring to FIG. 12, the computer system 1300 may include at least one of a processor 1310, a memory 1330, an input interface device 1350, an output interface device 1360, and a storage device 1340 communicating with one another through a bus 1370. The computer system 1300 may also include a communication device 1320 coupled to a network. The processor 1310 may be or include a central processing unit (CPU) or a semiconductor device that executes instructions stored in the memory 1330 or in the storage device 1340. The memory 1330 and the storage device 1340 may include various types of volatile or nonvolatile storage media. For example, the memory may include a read-only memory (ROM) and a random access memory (RAM). In example embodiments of the present disclosure, the memory may be located inside or outside the processor, and may be connected to the processor through various known means. The memory is or includes various types of volatile or nonvolatile storage media, and for example, may include a read-only memory (ROM) or a random access memory (RAM).

Accordingly, example embodiments of the present disclosure may be implemented as a method implemented in a computer or a non-transitory computer-readable medium storing computer-executable instructions. In an example embodiment, when executed by the processor, computer-readable instructions may perform a method according to at least one aspect of the present disclosure.

The communication device 1320 may transmit or receive wired signals or wireless signals.

Additionally, the method according to an example embodiment of the present disclosure may be implemented in the form of program instructions that can be executed through various computer means and recorded on a computer-readable medium.

The computer-readable medium may include program instructions, data files, data structures, etc., singly or in combination. The program instructions recorded on the computer-readable medium may be specially designed and configured for the example embodiments of the present disclosure, or may be known and usable by those skilled in the art of computer software. Computer-readable recording media may include a hardware device configured to store and perform program instructions. For example, the computer-readable recording media may be or include magnetic media such as hard disks, floppy disks, and magnetic tapes, optical media such as CD-ROMs and DVDs, magneto-optical media such as floptical disks, ROM, RAM, flash memory, etc. The program instructions may include not only machine language codes such as that generated by a compiler, but also high-level language codes that can be executed by a computer through an interpreter, etc.

A system for protecting an authentication circuit according to embodiments of the present disclosure may include memory 1330 in which a program for the design and arrangement of a device for protecting the authentication circuit has been stored and a processor 1310 that executes the program.

The processor 1310 may design a protection device for the authentication circuit unit included in the battery protection circuit module, may generate an arrangement instruction for the protection device, and may generate an instruction to perform the application of external noise and protection-related verification for the authentication circuit unit.

The processor 1310 may design the specifications of a protection device that protects the authentication circuit unit connected to the output stage of the battery protection circuit module against external noise.

The processor 1310 may design a first resistor that is connected to the first preset node of the authentication circuit unit and that has a resistance value within a preset range and a first capacitor that is disposed at the second preset node of the authentication circuit unit and that has a capacitance value within a preset range, according to the specifications of a first manufacturer.

The processor 1310 may design a second capacitor that is connected to the first preset node of the authentication circuit unit and that has a capacitance value within a preset range and a third capacitor that is connected to the second preset node of the authentication circuit unit and that has a capacitance value within a preset range, according to the specifications of a second manufacturer.

The processor 1310 may dispose a protection device by determining whether a resistor disposed in the output unit of an authentication circuit for each manufacturer has been mounted or has not been mounted.

The processor 1310 may recognize the pull-up or pull-down of the resistor depending on whether the resistor disposed in the output unit for each manufacturer has been mounted or has not been mounted.

The processor 1310 may perform verification on at least any one of ESD, an overvoltage, an inverse voltage, a surge voltage, and confirmation of ROM information of the authentication circuit unit after the radiation of X-ray.

Hereinafter, any material that may be usable for the secondary battery according to examples of the present disclosure will be described.

As the positive electrode active material, a compound capable of reversibly intercalating/deintercalating lithium (e.g., a lithiated intercalation compound) may be used. For example, at least one of a composite oxide of lithium and a metal such as at least one of cobalt, manganese, nickel, and combinations thereof may be used.

The composite oxide may be or include a lithium transition metal composite oxide, and examples thereof may include at least one of a lithium nickel-based oxide, a lithium cobalt-based oxide, a lithium manganese-based oxide, a lithium iron phosphate-based compound, a cobalt-free nickel-manganese-based oxide, or a combination thereof.

**As** an example, a compound represented by at least any one of the following formulas may be used: LiₐA_{1-b}X_{b}O_{2-c}D_{c} (0.90≤a≤1.8, 0≤b≤0.5, 0≤c≤0.05); LiₐMn_{2-b}X_{b}O_{4-c}D_{c} (0.90≤a≤1.8, 0≤b≤0.5, 0≤c≤0.05); LiₐNi_{1-b-c}Co_{b}X_{c}O_{2-α}D_{α} (0.90≤a≤1.8, 0≤b≤0.5, 0≤c≤0.5, 0<α<2); LiₐNi_{1-b-c}Mn_{b}X_{c}O_{2-α}D_{α} (0.90≤a≤1.8, 0≤b≤0.5, 0≤c≤0.5, 0<α<2); LiₐNi_{b}Co_{c}L¹_{d}GₑO₂ (0.90≤a≤1.8, 0≤b≤0.9, 0≤c≤0.5, 0≤d≤0.5, 0≤e≤0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn_{1-b}G_{b}O₂ (0.90≤a≤1.8, 0.001≤b≤0.1); LiₐMn₂G_{b}O₄ (0.90≤a≤1.8, 0.001≤b≤0.1); LiₐMn_{1-g}G_{g}PO₄ (0.90≤a≤1.8, 0≤g≤0.5); Li_{(3-f)}Fe₂(PO₄)₃ (0≤f≤2); and LiₐFePO₄ (0.90≤a≤1.8).

In the above formulas: A is or includes at least Ni, Co, Mn, or a combination thereof; X is or includes at least Al, Ni, Co, Mn, Cr, Fe, Mg, Sr, V, a rare earth element, or a combination thereof; D is or includes at least O, F, S, P, or a combination thereof; G is or includes at least Al, Cr, Mn, Fe, Mg, La, Ce, Sr, V, or a combination thereof; and L1 is or includes at least Mn, Al, or a combination thereof.

**A** positive electrode for a lithium secondary battery may include a current collector and a positive electrode active material layer formed on the current collector. The positive electrode active material layer may include a positive electrode active material and may further include a binder and/or a conductive material.

The content of the positive electrode active material is in a range of about 90 wt% to about 99.5 wt% on the basis of 100 wt% of the positive electrode active material layer, and the content of the binder and the conductive material is in a range of about 0.5 wt% to about 5 wt%, respectively, on the basis of 100 wt% of the positive electrode active material layer.

The current collector may be or include aluminum (Al) but is not limited thereto.

The negative electrode active material may include a material capable of reversibly intercalating/deintercalating at least one of lithium ions, lithium metal, an alloy of lithium metal, a material capable of being doped and undoped with lithium, or a transition metal oxide.

The material capable of reversibly intercalating/deintercalating lithium ions may be or include a carbon-based negative electrode active material, which may include, for example, at least crystalline carbon, amorphous carbon, or a combination thereof. Examples of the crystalline carbon may include graphite, such as natural graphite or artificial graphite, and examples of the amorphous carbon may include at least one of soft carbon, hard carbon, a pitch carbide, a meso-phase pitch carbide, sintered coke, and the like.

A Si-based negative electrode active material or a Sn-based negative electrode active material may be used as the material capable of being doped and undoped with lithium. The Si-based negative electrode active material may be or include at least silicon, a silicon-carbon composite, SiOx (0 < x < 2), a Si-based alloy, or a combination thereof.

The silicon-carbon composite may be or include a composite of silicon and amorphous carbon. According to one example embodiment, the silicon-carbon composite may be in the form of a silicon particle and amorphous carbon coated on the surface of the silicon particle.

The silicon-carbon composite may further include crystalline carbon. For example, the silicon-carbon composite may include a core including crystalline carbon and silicon particle and an amorphous carbon coating layer on the surface of the core.

A negative electrode for a lithium secondary battery may include a current collector and a negative electrode active material layer disposed on the current collector. The negative electrode active material layer may include a negative electrode active material and may further include a binder and/or a conductive material.

For example, the negative electrode active material layer may include about 90 wt % to about 99 wt % of a negative electrode active material, about 0.5 wt % to about 5 wt % of a binder, and about 0 wt % to about 5 wt % of a conductive material.

A non-aqueous binder, an aqueous binder, a dry binder, or a combination thereof may be used as the binder. When an aqueous binder is used as the negative electrode binder, a cellulose-based compound capable of imparting viscosity may be further included.

As the negative electrode current collector, at least one of copper foil, nickel foil, stainless steel foil, titanium foil, nickel foam, copper foam, conductive metal-coated polymer substrate, and combinations thereof may be used.

An electrolyte for a lithium secondary battery may include a non-aqueous organic solvent and a lithium salt.

The non-aqueous organic solvent may constitute a medium through which ions involved in the electrochemical reaction of the battery can move.

The non-aqueous organic solvent may be or include at least a carbonate-based, an ester-based, an ether-based, a ketone-based, an alcohol-based solvent, an aprotic solvent, and may be used alone or in combination of two or more.

Depending on the type of lithium secondary battery, a separator may be present between the first electrode plate (e.g., the negative electrode) and the second electrode plate (e.g., the positive electrode). As the separator, at least polyethylene, polypropylene, polyvinylidene fluoride, or a multilayer film of two or more layers thereof may be used.

The separator may include a porous substrate and a coating layer including an organic material, an inorganic material, or a combination thereof on one or both surfaces of the porous substrate.

The organic material may include a polyvinylidene fluoride-based polymer or a (meth)acrylic polymer.

The inorganic material may include inorganic particles such as at least one of Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and combinations thereof but is not limited thereto.

The organic material and the inorganic material may be mixed in one coating layer or may be in the form of a coating layer containing an organic material and a coating layer containing an inorganic material that are laminated on each other.

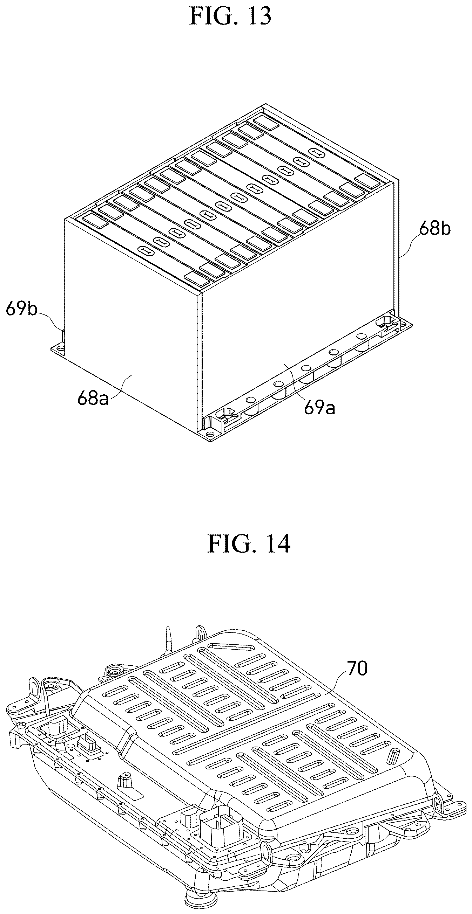

FIG. 13 is an illustration of a secondary battery module in which secondary batteries manufactured according to examples of the present disclosure are arranged. With the increase in secondary battery capacity for driving electric vehicles, and the like, a secondary battery module may be manufactured by arranging and connecting a plurality of secondary battery cells transversely and/or longitudinally. The plurality of secondary batteries may be arranged in a space defined by a pair of facing end plates 68a and 68b and a pair of facing side plates 69a and 69b. The secondary batteries may be designed appropriately in arrangement (direction) and number to obtain desired voltage and current specifications.

FIG. 14 is an illustration schematically showing the configuration of a battery pack 70 according to example embodiments of the present disclosure. Referring to FIG. 13, a battery pack 70 may include an assembly to which individual batteries are electrically connected, and a pack housing accommodating the same. In the drawings, for convenience of illustration, components including a bus bar, a cooling unit, external terminals for electrically connecting batteries, etc., are not shown.

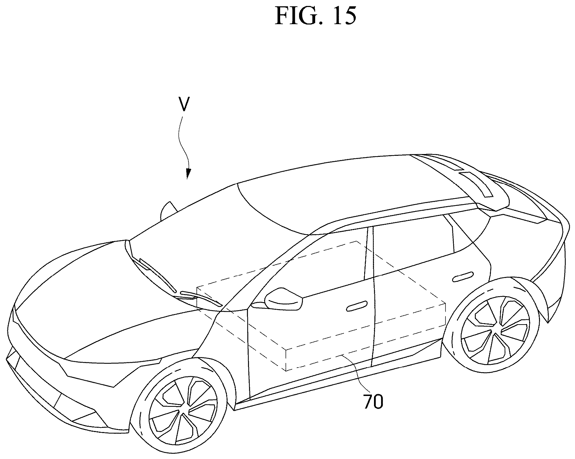

The battery pack 70 may be mounted on (or in) a vehicle. The vehicle may be, for example, an electric vehicle, a hybrid vehicle, a plug-in hybrid vehicle, and the like. The vehicle may be a four-wheeled vehicle or a two-wheeled vehicle but is not limited thereto. FIG. 15 shows a vehicle V which includes the battery pack 70 shown in FIG. 14 on the lower body thereof. The vehicle V may operate by (e.g., may be powered by) receiving power from the battery pack 70.

However, effects that can be achieved through the present disclosure are not limited to the above-described effects, and other technical effects not mentioned will be clearly understood by those skilled in the art from the description of the invention described below.

Although the present disclosure has been described above with respect to example embodiments thereof, the present disclosure is not limited thereto. Various modifications and variations can be made thereto by those skilled in the art within the present disclosure and the scope of the appended claims.

A secondary battery can be charged and discharged, for example, according to the following method.

CCCV charging is a charging method in which constant current (CC) charging is performed until the voltage reaches a predetermined level, and then constant voltage (CV) charging is performed until the current flowing becomes small, specifically, until it reaches a termination current value.

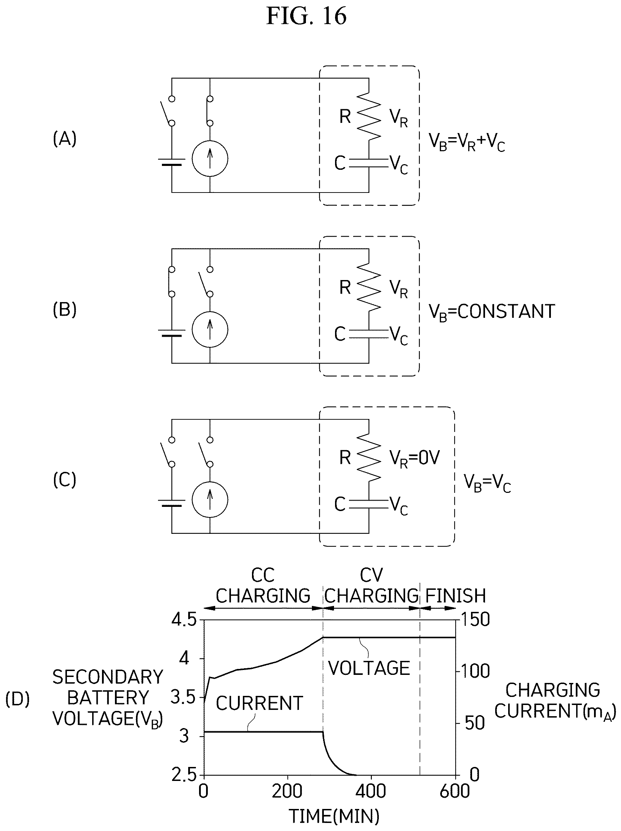

During the CC charging period, as shown in FIG. 16(A), the switch of the constant current power source is turned on, and the switch of the constant voltage power source is turned off, allowing a constant current I to flow through the secondary battery. In this period, since the current I is constant, the voltage VR applied to the internal resistance R is also constant, according to Ohm's law (VR = R × I). Meanwhile, the voltage VC applied to the capacity C of the secondary battery increases over time. Therefore, the battery voltage VB of the secondary battery also increases over time.

When the secondary battery voltage VB reaches a predetermined voltage, for example, 4.3V, the charging mode is switched from CC charging to CV charging. During CV charging, as shown in FIG. 16(B), the switch of the constant voltage power source is turned on and the switch of the constant current power source is turned off, so the battery voltage VB of the secondary battery remains constant. Meanwhile, the voltage VC applied to the capacity C of the secondary battery increases over time. Since VB = VR + VC must be satisfied, the voltage VR applied to the internal resistance R decreases over time. As the voltage VR applied to the internal resistance R decreases, the current I flowing through the secondary battery also decreases according to Ohm's law (VR = R × I).

When the current I flowing through the secondary battery reaches a predetermined current, for example, about 0.01C, the charging process is terminated. When the CCCV charging is completed, as shown in FIG. 16(C), all switches are turned off, and the current I becomes zero. Therefore, the voltage VR applied to the internal resistance R becomes 0V. However, since the voltage VR applied to the internal resistance R has already been sufficiently reduced by the CV charging, even if there is no further voltage drop across the internal resistance R, the secondary battery voltage VB hardly decreases.

FIG. 16(D) shows an example of the secondary battery voltage VB and the charging current during the CCCV charging process and after the CCCV charging is completed. Even after the CCCV charging is completed, the secondary battery voltage VB hardly decreases.

Although the present invention has been described with reference to limited embodiments and drawings, the invention is not limited thereto, and various modifications and alterations can be made by those of ordinary skill in the art without departing from the scope of the invention as defined by the claims below.

## Claims

1. A battery protection circuit module to which an authentication circuit unit (410; 420) is applied, the battery protection circuit module comprising:
an authentication circuit unit (410; 420) connected to an output stage of the battery protection circuit module; and
a protection device configured to protect the authentication circuit unit (410; 420) against external noise.

2. The battery protection circuit module as claimed in claim 1, wherein the protection device is connected to a terminal of the authentication circuit unit (410; 420) and is differently disposed depending on specifications of a manufacturer.

3. The battery protection circuit module as claimed in claim 1 or 2, wherein according to specifications of a first manufacturer, the protection device comprises a first resistor disposed to have a resistance value within a predetermined range at a first preset node of the authentication circuit unit (410; 420) .

4. The battery protection circuit module as claimed in claim 1, 2, or 3, wherein according to specifications of a first manufacturer, the protection device comprises a first capacitor disposed to have a capacitance value within a predetermined range at a second preset node of the authentication circuit unit (410; 420).

5. The battery protection circuit module as claimed in any one of claims 1 to 4, wherein according to specifications of a second manufacturer, the protection device comprises a second capacitor disposed to have a capacitance value within a predetermined range at a first preset node of the authentication circuit unit (410; 420).

6. The battery protection circuit module as claimed in any one of claims 1 to 5, wherein according to specifications of a second manufacturer, the protection device comprises a third capacitor disposed to have a capacitance value within a predetermined range at a second preset node of the authentication circuit unit (410; 420).

7. The battery protection circuit module as claimed in any one of claims 1 to 6, wherein a protection device comprising a bidirectional diode is disposed in an output stage of the authentication circuit unit (410; 420).

8. The battery protection circuit module as claimed in any one of claims 1 to 7, wherein authentication circuit product characteristics of a plurality of manufacturers are incorporated into the authentication circuit unit (410; 420).

9. The battery protection circuit module as claimed in any one of claims 1 to 8, wherein the protection device is disposed through pin-to-pin arrangement and protects the authentication circuit unit (410; 420), optionally wherein:
the authentication circuit unit (410; 420) comprises an authentication circuit of a first manufacturer and an authentication circuit of a third manufacturer, and
the authentication circuit unit (410; 420) is driven and executed by recognizing a set resistance value, and/ or wherein the protection device comprises a resistor disposed in each output unit for each of the first manufacturer and the third manufacturer, and/ or wherein in a case of the third manufacturer, a resistor connected to the authentication circuit of the first manufacturer is not mounted, a resistor connected to the authentication circuit of the third manufacturer is mounted, and the authentication circuit unit (410; 420) is driven by recognizing a resistance value of the resistor connected to the output stage and recognizes a pull-up of the resistor through an output terminal of the third manufacturer.

10. The battery protection circuit module as claimed in claim 9, wherein the protection device comprises a resistor disposed in each output unit for each of the first manufacturer and the third manufacturer and the authentication circuit unit (410; 420) is driven by recognizing a resistance value of the resistor connected to the output stage and recognizes a pull-down of the resistor through an output terminal of the first manufacturer.

11. A method of protecting an authentication circuit unit (410; 420), the method comprising steps of:
(a) designing a protection device for an authentication circuit unit (410; 420) included in the battery protection circuit module;
(b) disposing the protection device; and
(c) performing an application of external noise and protection-related verification for the authentication circuit unit (410; 420).

12. The method as claimed in claim 11, wherein the step (a) comprises designing specifications of the protection device that protect the authentication circuit unit (410; 420) connected to an output stage of the battery protection circuit module against external noise, optionally wherein the step (a) comprises designing a first resistor that is connected to a first preset node of the authentication circuit unit (410; 420) and that has a resistance value within a preset range and a first capacitor that is disposed at a second preset node of the authentication circuit unit (410; 420) and that has a capacitance value within a preset range, according to specifications of a first manufacturer.

13. The method as claimed in claim 12, wherein the step (a) comprises designing a second capacitor that is connected to a first preset node of the authentication circuit unit (410; 420) and that has a capacitance value within a preset range and a third capacitor that is connected to a second preset node of the authentication circuit unit (410; 420) and that has a capacitance value within a preset range, according to specifications of a second manufacturer.

14. The method as claimed in claim 11, 12, or 13, wherein the step (b) comprises disposing the protection device by determining whether a resistor disposed in an output unit of an authentication circuit for each manufacturer has been mounted or has not been mounted, optionally wherein the step (b) comprises recognizing a pull-up or pull-down of the resistor depending on whether the resistor disposed in the output unit for each manufacturer has been mounted or has not been mounted.

15. The method as claimed in any one of claims 11 to 14, wherein the step (c) comprises performing verification on at least one of ESD, an overvoltage, an inverse voltage, a surge voltage, and confirmation of ROM information of the authentication circuit unit (410; 420) after a radiation of X-ray.
